(19) Europäisches Patentamt

European Patent Office

Office européen des brevets

(11) **EP 1 333 328 A2**

(12) **EUROPEAN PATENT APPLICATION**

(43) Date of publication:
06.08.2003 Bulletin 2003/32

(51) Int Cl.⁷: **G03F 7/20**

(21) Application number: **03250496.1**

(22) Date of filing: **28.01.2003**

(84) Designated Contracting States:
**AT BE BG CH CY CZ DE DK EE ES FI FR GB GR HU IE IT LI LU MC NL PT SE SI SK TR**
Designated Extension States:
**AL LT LV MK RO**

(30) Priority: **29.01.2002 JP 2002020212**

(71) Applicant: **CANON KABUSHIKI KAISHA Tokyo (JP)**

(72) Inventor: **Miyake, Akira, Canon Kabushiki Kaisha Tokyo (JP)**

(74) Representative:
**Beresford, Keith Denis Lewis et al**
**BERESFORD & Co.**
**2-5 Warwick Court,**
**High Holborn**
**London WC1R 5DH (GB)**

(54) **Plasma light source apparatus, exposure apparatus and its control method and device fabrication method**

(57) An exposure apparatus having a plasma light source and a shutter provided between the plasma light source and an initial-stage optical device of an illumination system. The shutter is closed, and light emission by the plasma light source is started prior to the start of exposure processing by a stabilization period. When the stabilization period has elapsed, the exposure processing including a shutter opening operation is started. The stabilization period is equal to or longer than time necessary for stabilization of light emission intensity of the plasma light source. The stabilization period is previously measured and stored into a memory of controller 102. This maintains a long life of multilayer film mirror, and prevents the fluctuations in EUV light emission intensity due to the temperature change of the light source and accompanying change of the size of fine pattern and degradation of resolution and the like, thus enables stable transfer of fine pattern.

**FIG. 1**

## Description

FIELD OF THE INVENTION

The present invention relates to an exposure apparatus which can transfer a fine circuit pattern, a plasma light source apparatus appropriate to the exposure apparatus and control method for the exposure apparatus, and a device fabrication method using the exposure apparatus.

BACKGROUND OF THE INVENTION

Conventionally, reduced projection exposure is performed as a lithography technique for fabrication of fine semiconductor device such as a semiconductor memory or a logic circuit.

In the demagnifying projection exposure, the transferable minimum size is proportional to the wavelength of light used for transfer, but inversely proportional to the numerical aperture of projection optical system. To transfer a fine circuit pattern, it is necessary to reduce the wavelength of the light. For this purpose, the wavelength of ultraviolet light used in exposure is short. For example, mercury lamp i ray (wavelength: 365 nm), KrF excimer laser (wavelength: 248 nm) and ArF excimer laser (wavelength: 193 nm) are used.

However, finer semiconductor devices are rapidly developed, and there is a limit to lithography using ultraviolet light. Accordingly, to efficiently print a very fine circuit pattern having a size of e.g. 0.1 $\mu$m or less, developed is a reduced projection exposure apparatus using extreme ultraviolet light (EUV light) having a wavelength (about 10 to 15 nm) shorter than wavelengths of ultraviolet rays.

In such EUV light area, as the amount of absorption by material is very large, a lens optical system utilizing light refraction is not practical. Accordingly, in the exposure apparatus using EUV light, a reflection optical system is used. In this case, a reticle is a reflective type reticle. This reticle is obtained by forming a pattern of absorption agent to be transferred on a mirror.

As a reflective type optical device constructing an exposure apparatus using EUV light, a multilayer film mirror and a grazing incidence total reflection mirror are employed. In an EUV area, as a substantial part of reflective index is slightly less than 1, total reflection occurs if EUV light is used in grazing incidence as closely to the surface as possible. Generally, in grazing incidence within several degrees from the surface, several 10% or higher reflectivity is obtained. However, in this grazing incidence, as the freedom of optical designing is reduced, such grazing incidence total reflection mirror cannot be used in the projection optical system without difficulty.

As the mirror for EUV light used at an incident angle close to normal incidence, a multilayer film mirror obtained by alternately depositing 2 types of materials having different optical constants is employed. In the multilayer film mirror, molybdenum and silicon are alternately deposited on the surface of glass substrate polished to have a precise shape. As the thicknesses of the layers, the thickness of the molybdenum layer is about 2 nm, that of the silicon layer is about 5 nm, and the number of deposited layers is about 40 pairs. The total thickness of the 2 types of material layers is called a film period. In the above example, the film period is 2 nm+ 5 nm = 7 nm.

When EUV light is inputted to this multilayer film mirror, a particular wavelength of EUV light is reflected. Assuming that the incident angle is $\theta$, the wavelength of EUV light, $\lambda$, and the film period, d, only EUV light having a narrow bandwidth with $\lambda$ as the center, approximately satisfying Bragg's expression

$$2 \times d \times \cos\theta = \lambda$$

is efficiently reflected. The bandwidth at this time is about 0.6 to 1 nm.

The reflectivity of the EUV light is about 0.7 at the maximum, and the unreflected EUV light is absorbed in the multilayer film or the substrate, and the most part of the energy becomes heat.

As the amount of loss of light in the multilayer film mirror used in the EUV area is large in comparison with a mirror for visible light, the number of mirrors must be reduced to a minimum number. To realize a wide exposure area by a reduced number of mirrors, a method of simultaneously scanning a reticle and a wafer, by using only a thin ring field, away from an optical axis by a predetermined distance (scan exposure), is considered so as to transfer a wide area.

However, in the conventional EUV light exposure apparatus has the following problem. A laser plasma light source used as an EUV light source irradiates a target material with high-intensity pulse laser light, to cause high-temperature plasma, then EUV light having a wavelength of e.g. about 13 nm radiated from the plasma is utilized. High-speed gas molecules and charged particles are emitted from the plasma. Further, in some cases, the high-speed plasma particles collide with a part of target material supply device surface (spatter phenomenon), thereby atoms of the surface are scattered. These particles are called debris. If an initial stage mirror of illumination system is irradiated with the debris, the multilayer film on the mirror is damaged.

As its mechanism, the following facts are given:

· the multilayer structure is broken by the ion energy
· the target material and material of the target supply device are deposited on the multilayer film and become an EUV light absorbing layer
· as the multilayer film is heated, recrystalization or counter diffusion of materials, constructing the film, changes the film structure

In a case where a discharge plasma light source is used as the EUV light source, a similar problem occurs. In the discharge plasma light source, a pulse voltage is applied to an electrode in a gas to cause high-temperature plasma, and EUV light having a wavelength of e.g. about 13 nm radiated from the plasma is utilized. High-speed gas molecules and charged particles are emitted from the plasma. Further, in some cases, the high-speed plasma particles collide with a surface of the electrode or insulating member holding the electrode (spatter phenomenon), thereby atoms of the surface are scattered. If an initial stage mirror of illumination system is irradiated with the debris, the multilayer film on the mirror is damaged. The reflectivity of the multilayer film mirror is gradually reduced as the EUV light source is operated, by the above phenomenon. When the reflectivity of the multilayer film reflection mirror is about 90% of the initial reflectivity, it is determined that the multilayer film mirror is at the end of its life and the mirror must be replaced with new one.

As a method for extending the life of the multilayer film mirror, Japanese Published Unexamined Patent Application No. Hei 2000-349009 discloses an example of providing a filter in a light focusing position in the rear of the initial stage mirror of illumination system. However, upon use of filter, to allow the EUV light to effectively pass through the filter, the filter must be a very thin film. For example, to attain 70% transmittance of EUV light having a wavelength of 13 nm, the film thickness of the filter, if using silicon and beryllium, must be about 0.2 μm. Since a self-supported film cannot be formed by using this thin film, in the above patent application, the filter is provided around a position where the size of light flux focused by the initial stage mirror is the minimum, thereby the filter size is reduced to a minimum. Further, as the thin film filter is weak against heat and easily damaged, it is difficult to provide the filter around the light source. That is, the filter cannot be provided between the light source and the initial stage mirror of the illumination system without difficulty.

Accordingly, in the method using the filter as above, the debris between the light source and the initial stage mirror of the illumination system cannot be prevented, and the life of the initial stage mirror cannot be extended.

One methodology for maintain a long life of the initial stage multilayer film mirror is to stop the operation of the EUV light source when exposure is not performed. That is, in step and scan exposure, the light source is operated during a period in which reticle stage and wafer stage are scanned in synchronization with each other while the resist is exposed, and without the period, the operation of the light source is stopped, so as to maintain a long life of the multilayer film mirror. For example, assuming that the period in which the synchronized scanning is performed while the resist is exposed is 0.2 seconds, and a period from exposure in one exposure area on the wafer to exposure in another exposure area is 0.8 seconds, an operation to cause light emission by the light source, only for 0.2 seconds, at 1-second intervals, is repeated. In this operation, the period of light source operation is 1/5 in comparison with the case of continuous operation of the light source, accordingly, the life of the multilayer film mirror can be extended to approximately 5 times.

In the case of laser plasma light source, the intensity of EUV light radiated from the light source changes depending on the temperature of target. Especially, in a case where the density of target gas is controled by gas adiabatic expansion or a high-density target is obtained by clustering in the gas, even if the temperature of emitted gas or the nozzle is slightly changed, the density of the target when irradiated with excitation laser is greatly changed, and the intensity of radiated EUV light is greatly changed. Also in the case of discharge plasma light source, the intensity of EUV light radiated from the light source is changed depending on the temperature of the electrode or gas.

If the intensity of EUV light radiated from the light source is fluctuated, the amount of the EUV light irradiated to the wafer is fluctuated, and the size of fine pattern to be transfer changes or the fine pattern cannot be transferred.

In the laser plasma light source, a part of the target material supply device is heated by scattered light of the excitation laser and particles radiated from the plasma. In a case where, the light source is operated for the intermittent light emission as described above to extend the life of the multilayer film mirror, as the plasma is intermittently generated, the temperature of the target gas and that of the nozzle vary due to light emission and stoppage of light emission by the light source. Accordingly, the density of the target when irradiated with the excitation laser is greatly changed, and the intensity of the radiated EUV light is greatly changed. Accordingly, the size of fine pattern to be transfer changes or the fine pattern cannot be transferred.

In the discharge plasma light source, the nozzle of gas target supply device or nozzle is heated by the particles radiated from the plasma, or the electrode is heated by Joule heat in the electrode. In a case where, the light source is operated for the intermittent light emission as described above to extend the life of the multilayer film mirror, as the plasma is intermittently generated, the temperature of discharged gas and that of the electrode vary due to light emission and stoppage of light emission of the light source. Accordingly, the density of the gas upon start of discharge is greatly changed, and the intensity of the radiated EUV light is greatly changed. Accordingly, the size of fine pattern to be transfer changes or the fine pattern cannot be transferred.

SUMMARY OF THE INVENTION

An embodiment of the present invention seeks to enable stable transfer of fine pattern while maintain a long life of optical device such as a multilayer film mirror in an exposure apparatus using a plasma light source.

In one embodiment, the present invention provides a plasma light source apparatus, comprising: a plasma light source that produces plasma light emission; an optical device to which a light emitted from the plasma light source is initially guided; and a shutter mechanism having a shutter capable of being inserted between the optical device and the plasma light source.

Optical features of the present invention will be apparent from the following description taken in conjunction with the accompanying drawings, in which like reference characters designate the same name or similar parts throughout the figures thereof.

BRIEF DESCRIPTION OF THE DRAWINGS

The accompanying drawings, which are incorporated in and constitute a part of the specification, illustrate embodiments of the invention.

Fig. 1 is a block diagram showing the schematic construction of EUV light exposure apparatus according to a first embodiment of the present invention;
Fig. 2 is a perspective view explaining the structure of shutter according to the first embodiment;
Fig. 3 is a perspective view explaining the structure of another shutter according to the first embodiment;
Fig. 4 is a graph showing an example of measured variations by pulse in EUV light intensity, radiated from a laser plasma EUV light source;
Figs. 5A and 5B are timing charts showing timings of wafer exposure, light emission by the light source and shutter opening/closing;
Fig. 6 is a block diagram showing the schematic construction of the EUV light exposure apparatus according to a second embodiment of the present invention;
Fig. 7 is an explanatory view of exposure in a ring exposure field;
Fig. 8 is a flowchart explaining an exposure processing operation including a shutter operation according to the first embodiment;
Fig. 9 is a flowchart explaining the exposure processing operation including the shutter operation according to the second embodiment;
Fig. 10 is a flowchart showing the flow of entire semiconductor device fabrication process; and
Fig. 11 is a flowchart showing the detailed flow of wafer process in Fig. 10.

DETAILED DESCRIPTION OF THE PREFERRED EMBODIMENTS

Preferred embodiments of the present invention will now be described in detail in accordance with the accompanying drawings.

<First Embodiment>

In the present embodiment, a shutter is provided between a plasma light source and an initial stage mirror of illumination system. The light source constantly emits light even when a resist is not exposed, and the shutter is opened only during a period in which reticle stage and wafer stage are scanned in synchronization with each other while the resist is exposed, such that EUV light is guided to the illumination system. This realizes stabilization of the light source and prevention of damage to the initial stage mirror of the illumination system. Hereinbelow, the present embodiment will be described in detail.

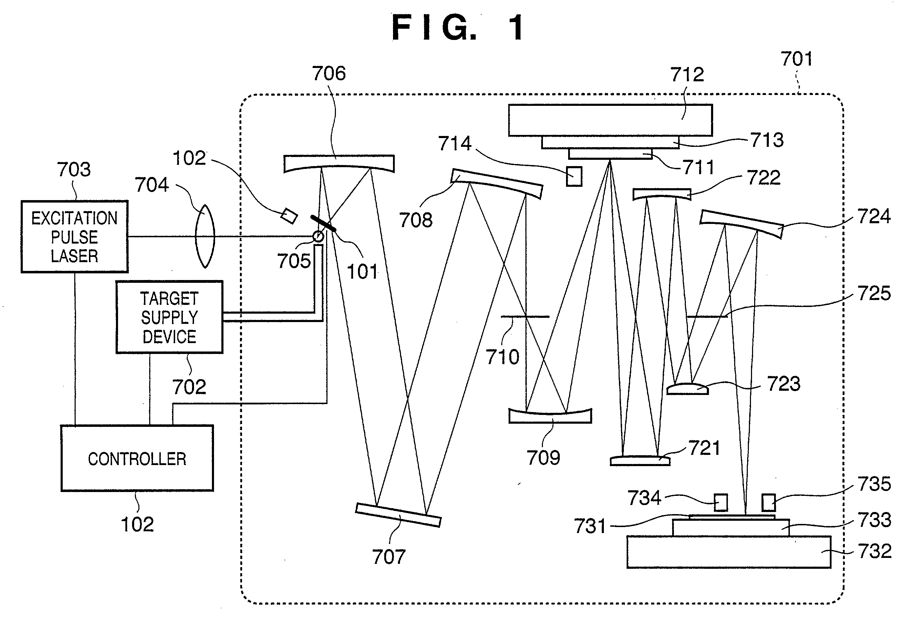

Fig. 1 is a block diagram showing the schematic construction of EUV light exposure apparatus according to the first embodiment of the present invention. As shown in Fig. 1, the EUV light exposure apparatus has an EUV light source, an illumination optical system, a reflective type reticle, a projection optical system, a reticle stage, a wafer stage, an alignment optical system, a vacuum system and the like.

A laser plasma light source is used as the EUV light source of the present embodiment. In the light source, a target material supplied in a vacuum chamber 701 is irradiated with high-intensity pulse laser light, to cause high-temperature plasma 705, and EUV light having a wavelength of e.g. about 13 nm radiated from the plasma is utilized. As the target material, a metal thin film, an inert gas, a liquid drop or the like is used, and supplied into the vacuum chamber 701 by a target supply device 702 having supply means such as gas jet. Further, the pulse laser light is outputted from excitation pulse laser 703, and applied to the target material via a condenser lens 704. It is preferable that the repetition frequency of the pulse laser is high to increase an average intensity of the radiated EUV light. The excitation pulse laser 703 is generally operated at the repetition frequency of several kHz.

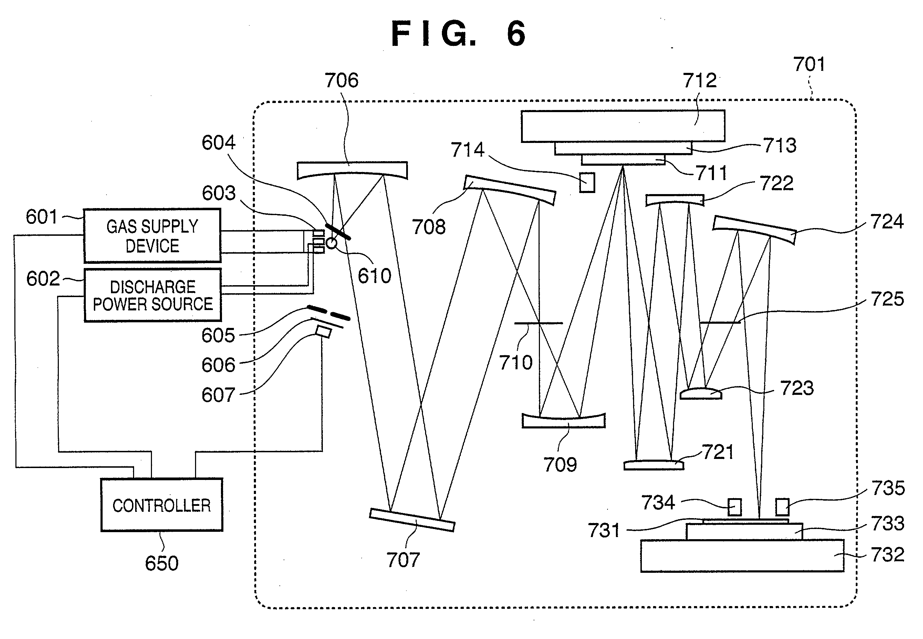

Note that a discharge plasma light source may be used as the EUV light source. The discharge plasma light source has e.g. the structure of EUV light source as shown in Fig. 6. In this structure, a gas is discharged around an electrode placed in a vacuum chamber, then a pulse voltage is applied to the electrode, to cause discharge and then high-temperature plasma, and EUV light having a wavelength of e.g. about 13 nm radiated from the plasma is utilized. It is preferable that the repetition frequency of the discharge is high to increase an average intensity of the radiated EUV light. The discharge is generally made at the repetition frequency of several kHz.

The illumination optical system has plural multilayer film or grazing incidence mirrors, an optical integrator and the like. In the illumination optical system, EUV light radiated from the plasma 705 is guided to the reticle 711 by an illumination-system first mirror 706, an optical integrator 707, an illumination-system second mirror 708 and an illumination-system third mirror 709.

The initial stage condenser mirror (illumination-system first mirror) 706 collects EUV light approximately isotropically radiated from the laser plasma 705. The optical integrator 707 uniformly illuminates a mask with a predetermined numerical aperture. Further, an aperture 710 which limits an irradiated area of reticle surface to a ring field is provided in a position conjugated with the reticle in the illumination optical system.

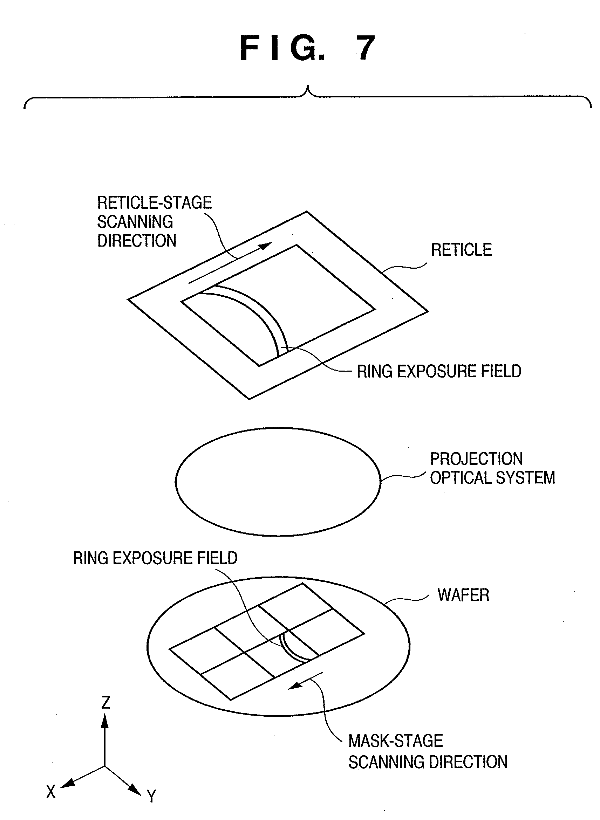

In this ring exposure field, the reticle is irradiated, and reflection light from the reticle is applied to the wafer through the projection optical system. As the amount of light loss in the multilayer film mirror used in the EUV area is larger in comparison with that in visible light mirror, the number of mirrors must be reduced to a minimum. To realize a wide exposure area by a reduced number of mirrors, a method of simultaneously scanning a reticle and a wafer, by using only a thin ring field away from an optical axis by a predetermined distance (scan exposure) is considered so as to transfer a wide area (See Fig 7). The ring illumination field is formed by the optical integrator 707, the front and rear mirrors, and the aperture 710 in the illumination optical system.

Plural mirrors are also used in the projection optical system. In Fig. 1, the reflected light from the reticle 711 is guided on a wafer 731 attached to a wafer chuck 733 by projection-system first to fourth mirrors (721 to 724). The efficiency of use of EUV light is higher when the number of mirrors is smaller, however, correction for aberration is difficult. The necessary number of mirrors for correction for aberration is about 4 to 6. The shape of reflecting surface of the mirror is a convex or concave spherical surface or aspherical surface. The numerical aperture NA is about 0.1 to 0.3.

The respective mirrors are formed by grinding and polishing a substrate, having high rigidity and hardness and small thermal expansion coefficient such as glass of low expansion coefficient or silicon carbide, to obtain a predetermined reflecting surface shape, and forming a multilayer film of molybdenum/silicon and the like on the reflecting surface. In a case where an incident angle is not constant depending on position within the mirror surface, as it is apparent from the above-described Bragg's expression, the wavelength of EUV light is shifted since the reflectivity increases depending on position of multilayer film having a constant film period. Accordingly, it is necessary to attain a film period distribution so as to efficiently reflect the EUV light having the same wavelength within the mirror surface.

A reticle stage 712 and a wafer stage 732 respectively have a mechanism for scanning in synchronism at a speed ratio proportional to a reduction scaling. In this embodiment, description will be made with a scanning direction within the reticle or wafer surface as X; a direction vertical to the direction X, as Y, and a direction vertical to the reticle or wafer surface, as Z.

The reticle 711 is held by the reticle chuck 713 on the reticle stage 712. The reticle stage 712 has a mechanism to move in the direction X at a high speed. Further, the reticle stage has a micro motion mechanism to slightly move in the directions X, Y and Z and rotational directions about the respective axes for positioning of the reticle 711. The position and orientation of the reticle stage 712 are measured by a laser interferometer (not shown), and the position and orientation are controlled based on the result of measurement.

The wafer 731 is held by the wafer chuck 733 on the wafer stage 732. As in the case of the reticle stage, the wafer stage 732 has a mechanism to move in the direction X at a high speed. Further, the wafer stage has a micro motion mechanism to slightly move in the directions X, Y and Z and rotational directions about the respective axes for positioning of the wafer 731. The position and orientation of the wafer stage 732 are measured by a laser interferometer (not shown), and the position and orientation are controlled based on the result of measurement.

Alignment detection mechanisms 714 and 734 measure the positional relation between the position of the reticle 711 and that of the optical axis of the projection optical system and the positional relation between the position of the wafer 731 and the optical axis of the projection optical system. The positions and angles of the reticle stage 712 and the wafer stage 732 are set such that a projection image of the reticle 711 coincides with a predetermined position of the wafer 731.

Further, a focus position of the wafer surface in the direction Z is measured by a focus position detection mechanism 735, and the position and angle of the wafer stage 732 are controlled, thereby the wafer surface is constantly held in an image formation position by the projection optical system during exposure.

When a first scan exposure is completed on the wafer 731, the wafer stage 732 step-moves in the directions X and Y to the next scan-exposure start position. Then the reticle stage 712 and the wafer stage 732 are scanned in synchronization with each other in the direction X at a speed ratio proportional to the reduction scaling of the projection optical system.

In this manner, the operation to scan the stages in synchronization with each other in a status where the reduced projection image of the reticle is formed on the wafer is repeated (step and scan), thus a reticle pattern is transferred to the entire wafer surface.

The EUV light is seriously absorbed by gas. For example, in a case where EUV light having a wavelength of 13 nm is propagated by 1 m in space filled with 10 Pa of air, about 50% of the light is absorbed. To avoid absorption by gas, the space where the EUV light is propagated must be maintained at pressure of at least $10^{-1}$Pa or lower or preferably $10^{-3}$Pa or lower.

Further, in a case where molecules including carbons such as carbon hydride remain in space where the optical device irradiated with the EUV light is placed, the carbon molecules are gradually attached to the surface of the optical device by light irradiation, and the EUV light is absorbed by the carbon attached to the optical device. Thus reduces the reflectivity. To prevent the attachment of carbon, the space where molecules including carbons such as carbon hydride remain in space where the optical device irradiated with the EUV light is placed must be maintained at pressure of at least $10^{-4}$Pa or lower or preferably $10^{-6}$Pa or lower. For this purpose, the light source, the optical devices of the illumination system and the projection optical system, the reticle, the wafer and the like are placed in the vacuum chamber 701, and the air is exhausted to satisfy the above degree of vacuum.

Further, in Fig. 1, reference numeral 101 denotes a shutter provided between the laser plasma light source 705 and the initial stage mirror 706 of the illumination system (illumination-system first mirror). Further, around the laser plasma light source 705, an EUV light intensity detector 102 is provided. In the EUV light exposure apparatus of the first embodiment, the plasma light source emits light even when a resist is not exposed, and the shutter 101 is opened only during a period in which reticle stage and wafer stage are scanned in synchronization with each other while the resist is exposed, such that EUV light is guided to the illumination system.

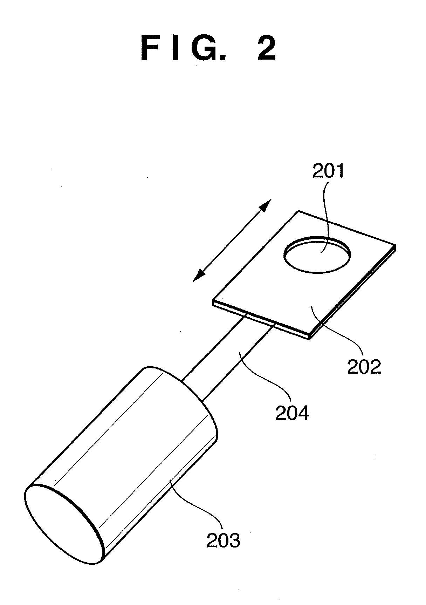

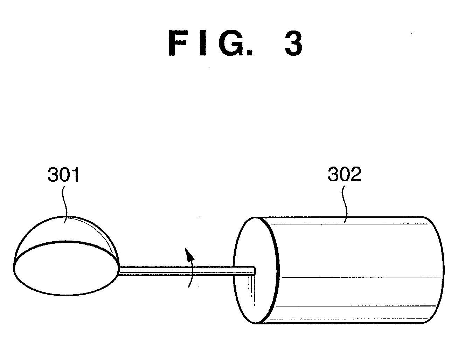

Figs. 2 and 3 show a particular example of the shutter 101. As the structure of the shutter, a structure as shown in Fig. 2 in which a shutter plate 202 having an aperture 201 is linearly moved by a linear drive actuator 203, a structure as shown in Fig. 3 in which a hemispherical shutter plate 301, having a hemispherical shell-like shape, is rotated by a rotary drive actuator 302, and the like, are given. It is preferable that the shutter plate is removable for cleaning and exchange.

Further, as the shutter plate 202 or the hemispherical shutter plate 301 is irradiated with electromagnetic waves in a wade-wavelength band and the debris from the EUV light source and the EUV light, heavy thermal load is imposed on the shutter plate. Accordingly, the shutter plate must be formed with material having high thermal resistance and high thermal conductivity. For example, high melting-point metal such as tungsten or molybdenum, ceramics such as silicon carbide, or metal having high thermal-conductivity such as copper coated with high melting-point or ceramics, may be used. Note that it is preferable that the actuator to drive the shutter plate is provided in the atmosphere (outside the chamber).

Further, a water-cooled pipe may be provided inside the shutter. In this case, in Fig. 2, the shutter and the water-cooled pipe are integrally moved in and out, and in Fig. 3, the shutter and the water cooled pipe are integrally rotated. At this time, it is preferable that the actuator in the atmosphere and the shutter are stiffly connected with each other via the water-cooled pipe, i. e., the water-cooled pipe itself corresponds with the driving axis. As the water-cooled pipe in the vacuum is not deformed, a sufficiently high-speed operation can be performed. Note that in the example of Fig. 2, the chamber in the driving axis portion is vacuum sealed via a bellows or the like, and in the example of Fig. 3, the chamber is vacuum sealed via a magnetic fluid seal or the like.

Note that as described above, as the structure of the shutter, if a large amount of debris is attached to the shutter, it must be cleaned or exchanged for new one, an easily-removable structure is desirable.

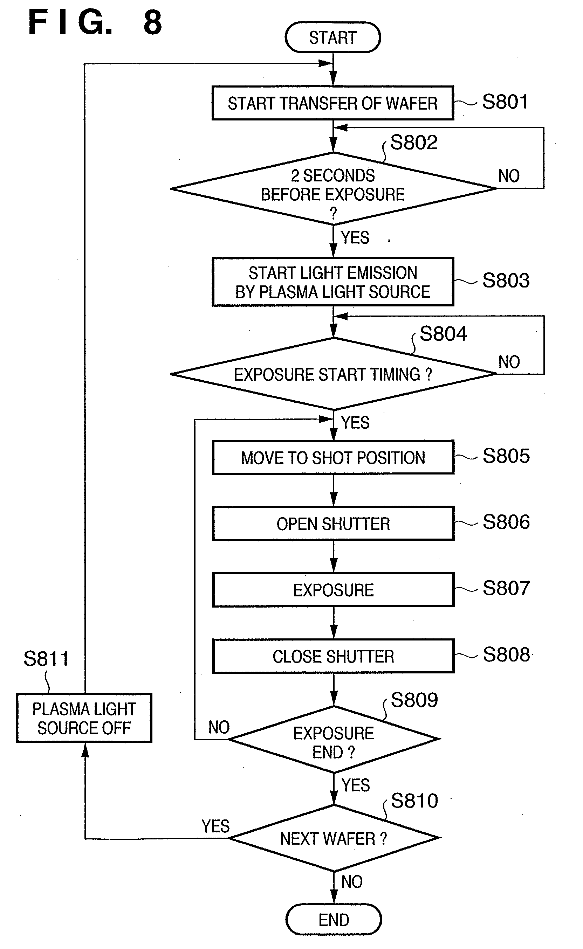

Further, in Fig. 1, numeral 102 denotes a controller which performs drive control on the wafer stage and the reticle stage, control on the wafer transfer, drive control on the excitation pulse laser 703 and the target supply device 702, and performs control including control on a driving portion for the shutter 101 to be described later with reference to the flowchart of Fig. 8.

Further, as a shutter driving method, driving by a linear introduction mechanism using a bellows from an actuator provided in the atmosphere, driving by a rotary introduction mechanism using magnetic fluid axis seal, a method of using an actuator in a vacuum chamber and the like, can be given. As the actuator, a mechanism using a pulse motor or a servo motor, a mechanism using air pressure or hydraulic-driven cylinder, and the like, can be employed.

It is preferable that time necessary for opening/closing the shutter is as short as possible. Since it is necessary to start to open the shutter before time to open the shutter, prior to start of exposure, and the illumination initial stage mirror is exposed to the debris and radiation from the EUV light source until the shutter is fully opened, if time necessary for opening/closing the shutter is long, the mirror is damaged for such time. To effectively prevent the damage to the mirror, it is preferable that the time necessary for opening/closing the shutter is shorter than time necessary for exposure in one exposure area on the wafer, further preferably, about 1/10 of the exposure time. For example, assuming that it takes 0.2 seconds to perform exposure in one exposure area on the wafer, it is preferable that the time necessary for opening/closing the shutter is within 0.2 seconds, further preferably, within 0.02 seconds.

The operation of the exposure apparatus of the present embodiment having the above construction will be described.

In the first embodiment, prior to exposure, fluctuations in light emission intensity of the light source are previously measured, by using the EUV light intensity detector 102 provided around the laser plasma light source 705. Photodiode, an ion chamber or the like may be used as the EUV light intensity detector 102.

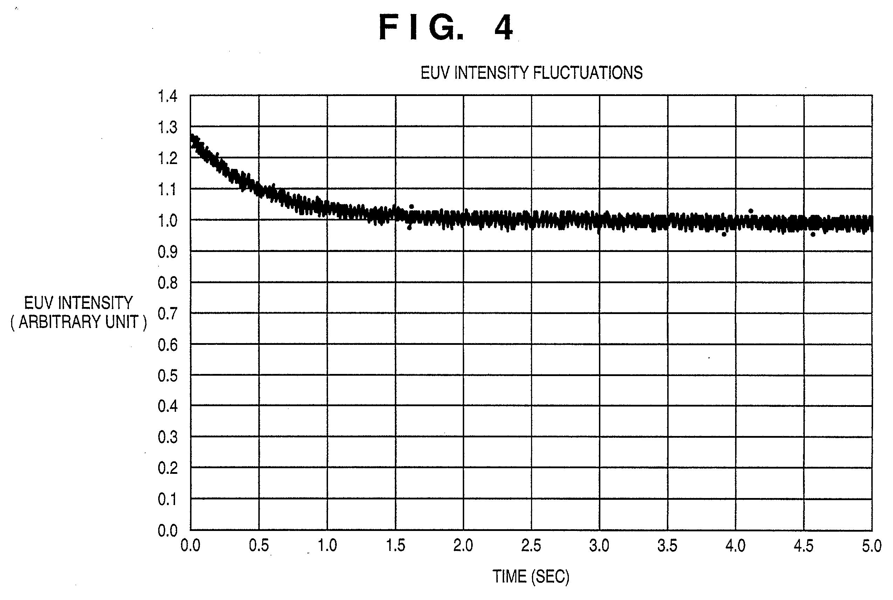

Fig. 4 shows an example in which variations by pulse in the intensity of EUV light, radiated from a laser plasma EUV light source. Time indicates time from the start of light emission. The intensity of radiated EUV light has variations by pulse, and further, immediately after the start of light emission, there is a wide range of intensity variations, then the variations are gradually converged to a fixed value. In the case of this light source, when about 2 seconds have elapsed from the start of light emission, the light emission intensity of the light source comes into a steady status. It can be understood that in the case of light source having this characteristic, if light emission by the light source is started 2 or more seconds before the start of exposure, the intensity variations during exposure can be reduced within a small range. Actually, the laser plasma light source performs light emission not in continuous form but in pulse form, the status where the output of pulse string is started is called the start of light emission.

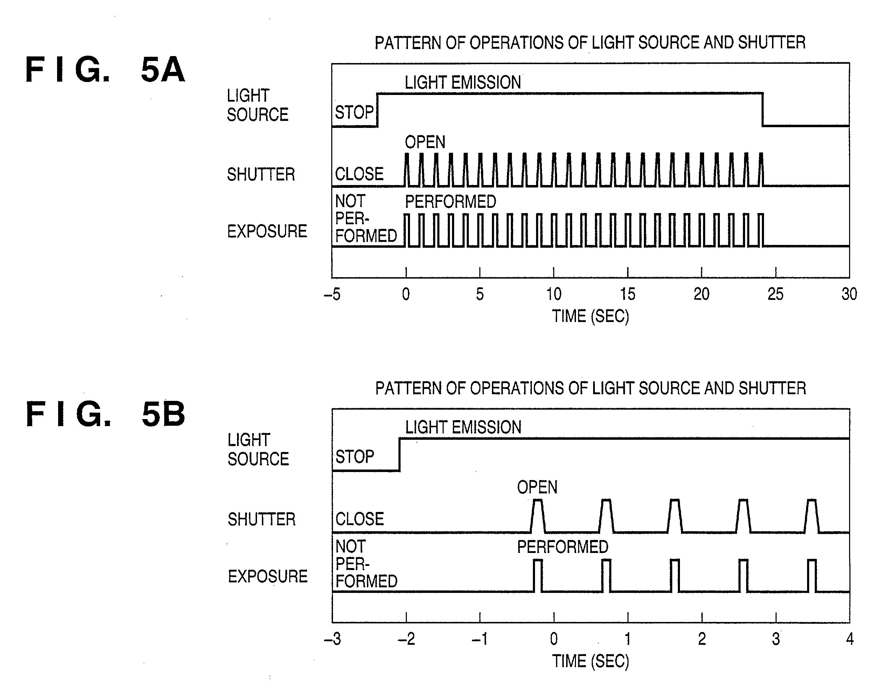

Figs. 5A and 5B are timing charts showing timings of wafer exposure, light emission by the light source and opening/closing of the shutter. Assuming that time for synchronous scanning and exposure for resist is 0.2 seconds and time from exposure in one exposure area to start of exposure in another exposure area is 0.8 seconds, as it takes 2 seconds before the light emission intensity of the light source becomes a steady status, i. e., as exposure interval<time for obtaining the steady status holds, it is understood that the light source must always emit light during exposure for one wafer. In this case, the shutter 101 provided between the light source and the illumination-system initial-stage mirror is closed immediately after the completion of resist exposure, and the shutter is opened immediately before the start of exposure in the next exposure area.

In a case where one wafer is exposed then is replaced with the next wafer, it takes long time for removal/attachment of wafer, measurement of wafer alignment, stage driving and the like. Assuming that the above time is about 10 seconds, light emission by the light source is stopped at a point where exposure for one wafer is completed, and the light emission by the light source is started such that light emission intensity becomes stable before exposure for the next wafer is started. In the present embodiment, as described in Fig. 4, since it is about 2 seconds before the light emission intensity of the light source is stabilized, light emission by the light source is started from 2 seconds before the start of exposure for the next wafer. The shutter 101 is close immediately after the completion of exposure for one wafer, and the shutter is opened immediately before exposure is started in the initial exposure area of the next wafer.

The above exposure processing operation including a shutter operation will be further described with reference to the flowchart of Fig. 8. At step S801, transfer of exposed wafer and transfer of wafer to be exposure-processed are started. Then at step S802, the process waits until 2 seconds before the start of exposure processing. Note that the timing of 2 second before the start of exposure processing can be detected by monitoring the progress of the transfer processing started at step S801.

If it is 2 seconds before the start of exposure, the process proceeds to step S803, at which light emission by the plasma light source is started. At step S804, it is determined whether or not the timing of the start of exposure has come. In this determination, it is determined whether or not the transfer of wafer has started and the exposure processing can be started. When the start of exposure processing is possible, about 2 seconds have elapsed from the start of light emission by the plasma light source, and the intensity of light emission by the light source is stable. Note the determination at step S804 may include determination as to whether or not 2 seconds have elapsed from the start of light emission by the plasma light source.

At the timing of the start of exposure, the process proceeds to step S805, at which the wafer is moved to an exposure shot position, then the shutter is opened and exposure is performed. When the exposure to the shot position has been completed, the shutter is closed (steps S806 to S808). Then at step S809, it is determined whether or not the exposure processing on the wafer has been completed. If there is an unprocessed shot position, the process returns to step S805 at which the above-described shot exposure processing is repeated. On the other hand, if it is determined at step S809 that the exposure processing on the wafer has been completed, the process proceeds to step S810, at which it is determined whether or not a next wafer to be exposed exists. If a wafer to be exposed exists, the process proceeds to step S811, at which the plasma light source is turned off, then the process returns to step S801. If there is no wafer to be exposed, the process ends from step S810.

Note that in the above processing, the "start of exposure" at steps S802 and S804 may include timing of movement to the initial exposure shot position of the wafer. In this case, if it is determined at step S804 that the timing of the start of exposure has come, the process directly proceeds from step S804 to step S806, at which the exposure operation is immediately started.

Note that as described above, in the EUV light exposure apparatus of the present embodiment, prior to exposure, variations in the light emission intensity of the light source are measured by using the EUV light intensity detector 102 provided around the laser plasma light source 705, and time of initial fluctuations in the intensity of light source is determined. This time is stored in a memory (not shown) of the controller 102, and is read upon execution of the processing in Fig. 8. Since the measurement is performed once regarding one type of light source, the EUV light intensity detector 102 may be removed after the completion of the measurement. Accordingly, one EUV light intensity detector 102 may be used for plural exposure apparatuses to measure the time of initial fluctuations in each light source. Otherwise, as the time of initial fluctuations in the light source intensity can be considered as approximately the same in the EUV light sources having the same structure, it may be arranged such that the fluctuations in the light emission intensity of the light source is measured in one exposure apparatus by using the EUV light intensity detector, and the times of initial fluctuations in the light source intensity in other exposure apparatuses are determined based on the measured fluctuations. In this case, it is not necessary to provide the EUV light intensity detector around the laser plasma light source of each exposure apparatus.

As described above, in the EUV light exposure apparatus of the present embodiment, the shutter in the immediately rear of the light source is opened and EUV light is guided to the illumination system only during a period in which the reticle stage and the wafer stage are scanned in synchronization with each other while the resist is exposed, and the shutter is closed without the above period, such that the multilayer film mirror is not exposed to the debris and radiation from the light source. For example, assuming that a period in which the synchronized scanning is performed while the resist is exposed is 0.2 seconds and a period from exposure in one exposure area on the wafer to exposure in another exposure area is 0.8 seconds, an operation to cause light emission by the light source, only for 0.2 seconds, is repeated at 1-second intervals. In this operation, the period in which the multilayer film mirror is exposed to the debris and radiation from the light source is 1/5 in comparison with the case of continuous operation of the light source without use of shutter, accordingly, the life of the multilayer film mirror can be extended to approximately 5 times.

Note that if the period from the start of light emission by the light source to the stabilization of light emission intensity is shorter than that from exposure in one exposure area on the wafer to exposure in the next exposure area, the light emission by the light source may be stopped during a period from the exposure in one area on. the wafer to the exposure in the next exposure area. That is, when exposure in one exposure area on the wafer is completed, light emission by the light source is immediately stopped and the shutter is closed. Then, light emission by the light source is started, prior to the time of start of exposure in the next exposure area, by time corresponding to the period from the start of light emission by the light source to the stabilization of light emission intensity.

Further, if the period from the start of light emission by the light source to the stabilization of light emission intensity is longer than that from exposure for one wafer to exposure for the next wafer, light emission by the light source must not be stopped even during the period from the exposure for one wafer to the exposure for the next wafer. In this case, light emission by the light source is not stopped while exposure is continuously performed on the wafers. Light emission by the light source may be stopped when exposure is not performed for long time since the reticle is exchanged for another one, the exposure condition is changed, or maintenance is performed in the semiconductor factory.

As described above, in the EUV light exposure apparatus of the present embodiment, light emission by the laser plasma light source is started prior to actual exposure for the wafer, by time necessary for stabilization of light emission intensity or longer time. The temperatures of the discharged gas and the nozzle are stable when the wafer is exposed. Accordingly, a constant density of the target is kept upon irradiation with the excitation laser, therefore, the intensity of EUV light radiated in wafer exposure is stable. This solves the problems that the size of fine pattern to be transferred is changed and the fine pattern cannot be transferred.

Further, according to the present embodiment, the shutter is provided between the light source and the initial stage mirror of the illumination system. The light source steadily emits light even when a resist is not exposed, and the shutter is opened only during a period in which the reticle stage and the wafer stage are scanned in synchronization with each other while the resist is exposed, such that EUV light is guided to the illumination system. This maintains a long life of the multilayer film mirror, and prevents the fluctuations in the EUV light emission intensity due to the temperature change of the light source and accompanying change of the size of fine pattern and degradation of resolution and the like, thus enables stable transfer of fine pattern.

<Second Embodiment>

In the first embodiment, the period in which the light emission intensity is unstable is previously measured, and light emission by the light source is started prior to the start of exposure based on the result of measurement. In the second embodiment, the fluctuations in the light emission intensity from the start of light emission are monitored, and exposure is started when it is determined that the light emission is in a stable status.

Fig. 6 is a block diagram showing the schematic construction of the EUV light exposure apparatus according to the second embodiment. In the first embodiment, the laser plasma light source is employed, but in the second embodiment, a discharge plasma light source is employed. In the discharge plasma light source, a gas is discharged from a gas supply device 601 around an electrode 603 placed in the vacuum chamber 701, then a pulse voltage from a discharge power source 602 is applied to the electrode 603 to cause discharge, thereby high-temperature plasma 610 is generated, and EUV light having a wavelength of e. g. 13 nm radiated from the plasma is utilized as exposure light. It is preferable that the repetition frequency of the discharge is high to increase an average intensity of the radiated EUV light, and the discharge is generally made at the repetition frequency of several kHz.

As in the case of the first embodiment, a shutter 604 is provided between the discharge plasma light source 610 and the illumination-system initial-stage mirror (illumination-system first mirror 706), so as to pass or block EUV light toward the illumination-system initial-stage mirror. Further, an EUV light intensity detector 607 is provided around the discharge plasma light source 610, to measure the intensity of the EUV light passed through a pinhole 605 and a filter 606.

As in the case of the first embodiment, the light source 610 steadily emits light even when a resist is not exposed, and the shutter 604 is opened only during a period in which the reticle stage and the wafer stage are scanned in synchronization with each other while the resist is exposed, such that EUV light is guided to the illumination system.

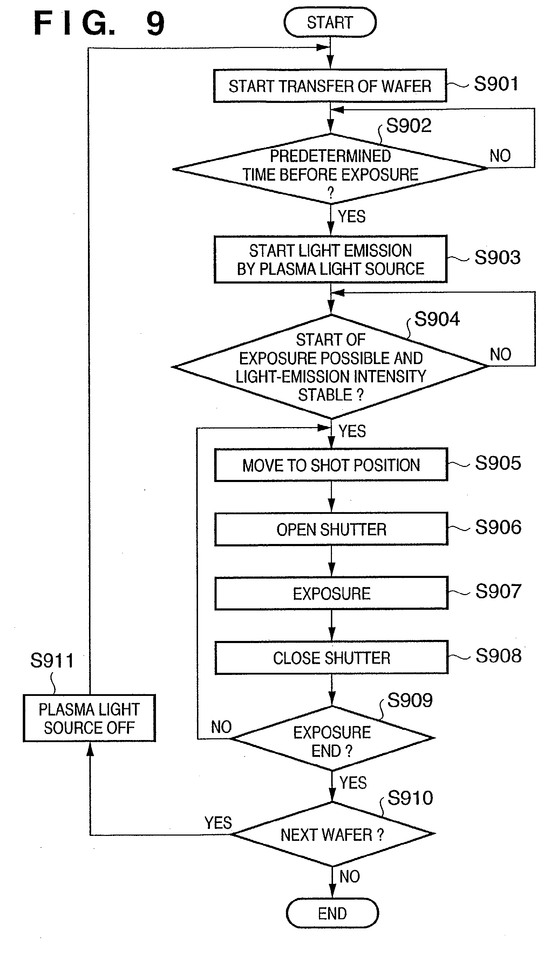

Numeral 650 denotes a controller which controls the wafer stage, the reticle stage, controls transfer of wafer, inputs a light intensity signal from the light intensity detector 607 and drives the gas supply device 601 and the discharge power source 602, thereby realizes processing in the flowchart of Fig. 9 to be described later.

In the EUV light exposure apparatus according to the second embodiment, the fluctuations in the light emission intensity by the EUV light source are constantly measured. The measurement is performed by the EUV light intensity detector 607 provided around the discharge plasma light source. Photodiode, an ion chamber or the like may be used as the EUV light intensity detector 607. As the EUV light intensity detector 607 of the present embodiment is always exposed to strong radiation and the debris, it is preferable that the detector is cooled for prevention of temperature rise. For example, a case of photodiode may be fixed to water-cooled copper block and cooled by the block. Further, the pinhole 605 and the filter 606, provided on the incident side of EUV light, may also be fixed to the water-cooled copper block and cooled by the block, thus temperature rise of the detector can be prevented.

The structure and driving of the shutter provided between the light source and the illumination-system initial-stage mirror are the same as those in the first embodiment.

In the EUV light exposure apparatus of the second embodiment, prior to wafer exposure, first, light emission by the discharge plasma light source is started. Then the intensity of EUV light radiated from the light source is measured by the EUV light intensity detector 607 provided around the light source. The output from the detector 607 is examined, thereby it is determined whether or not the intensity of the EUV light radiated from the light source is stable. That is, the output from the detector has fluctuations by pulse, and there are a wide range of fluctuations immediately after the start of light emission, then are converged to a fixed value over the course of time. When the amount of fluctuation in the output from the detector 607 is less than the fixed value, it is determined that the intensity of the EUV light radiated from the light source is stable, then the shutter 604 is opened and exposure is started. More particularly, first, a signal to open the shutter 604 is supplied to a shutter drive device, and when the shutter has been fully opened, an exposure start enable signal is supplied to a controller (not shown) to control an exposure sequence.

The controller which has received the exposure start enable signal starts an exposure operation. Immediately after the completion of exposure in each exposure area on a wafer, the shutter 604 is closed, then the shutter is opened immediately before the start of exposure in the next exposure area.

Further, when one wafer has been exposed and the wafer is replaced with the next wafer, it takes comparatively long time for wafer removal/attachment, measurement of wafer alignment and stage driving. Assuming that this period is 10 seconds, light emission by the light source is stopped upon completion of exposure for one wafer, then light emission by the light source is started prior to the start of exposure for the next wafer, by a predetermined period. Then, the intensity of EUV light radiated from the light source is measured by the EUV light intensity detector 607, then stabilization of the intensity of light emission by the light source is waited based on the signal from the detector, and exposure for the wafer is started.

The exposure processing operation including the shutter operation according to the second embodiment will be further described with reference to the flowchart of Fig. 9. At step S901, transfer of exposed wafer and transfer of wafer to be expose-processed are started. Then at step S902, the process waits until it is a predetermined period before the start of exposure processing (2 seconds in this embodiment). Note that the timing of 2 second before the start of exposure processing can be detected by monitoring the progress of the transfer processing started at step S801. Note that it is preferable that the predetermined period is approximately the same as the period from the start of light emission by the plasma light source to the stabilization of light emission intensity. In the present embodiment, the period is 2 seconds.

Accordingly, if it is 2 seconds before the start of exposure, the process proceeds to step S903, at which light emission by the plasma light source is started. At step S904, it is determined whether or not the transfer of wafer has been completed and the intensity of light emission by the plasma light source is stable.

If the above condition is satisfied, the process proceeds to step S905, at which the wafer is moved to an exposure shot position, then the shutter is opened and exposure is performed, and when the exposure to the shot position has been completed, the shutter is closed (steps S906 to S908). Then, at step S909, it is determined whether or not the exposure processing for the wafer has been completed, and if an unprocessed shot position still exists, the process returns to step S905, at which the above shot exposure processing is repeated. On the other hand, if it is determined at step S909 that the exposure processing for the wafer has been completed, the process proceeds to step S910, at which it is determined whether or not the next wafer to be exposed exists. If the next wafer to be exposed exists, the process proceeds to step S911, at which the plasma light source is turned off, and returns to step S901. If no wafer to be exposed exists, the process ends from step S910.

Note that in the above processing, the determination at step S904 as to whether or not exposure can be started may be performed upon completion of movement of the wafer to the initial exposure shot position. In this case, if it is determined at step S904 that exposure can be started, the process directly proceeds from step S904 to step S906, to immediately start the exposure operation.

As described above, in the EUV light exposure apparatus according to the second embodiment, the shutter 604 in the immediately rear of the light source is opened and EUV light is guided to the illumination system only during a period in which the reticle stage and the wafer stage are scanned in synchronization with each other while the resist is exposed, and the shutter 604 is closed without the above period, such that the multilayer film mirror is not exposed to the debris and radiation from the light source. In this method, as the period in which the multilayer film mirror is exposed to the debris and radiation from the light source can be reduced in comparison with the case of continuous operation of the light source without use of shutter, the life of the multilayer film mirror can be extended.

Further, in the EUV light exposure apparatus according to the second embodiment, light emission by the discharge plasma light source 610 is started prior to the start of exposure for the wafer 731, the light emission intensity is monitored, and it is determined whether or not the light emission has been stabled. Accordingly, upon exposure for the wafer, the temperatures of discharged gas and the nozzle are stable and the density of target upon irradiation with excitation laser is constant. The intensity of the EUV light radiated in the wafer exposure is stable, and the problem that the size of fine pattern to be transferred is changed and the fine pattern cannot be transferred can be prevented.

That is, as the shutter is provided between the discharge plasma light source and the illumination-system initial-stage mirror, the light source continuously emits light even when the resist is not exposed, and the shutter is opened such that EUV light is guided to the illumination system only during a period in which the reticle stage and the wafer stage are scanned in synchronization with each other while the resist is exposed. This maintains a long life of the multilayer film mirror, and prevents the fluctuations in the EUV light emission intensity due to the temperature change of the light source and accompanying change of the size of fine pattern and degradation of resolution and the like, thus realizes exposure apparatus and exposure method using EUV light which enable stable transfer of fine pattern.

Note that the combination of light source and control method in the first embodiment may be replaced with that in the second embodiment. That is, the discharge plasma light source may be employed in the control procedure in the first embodiment, and further, the laser plasma light source may be employed in the control procedure in the second embodiment.

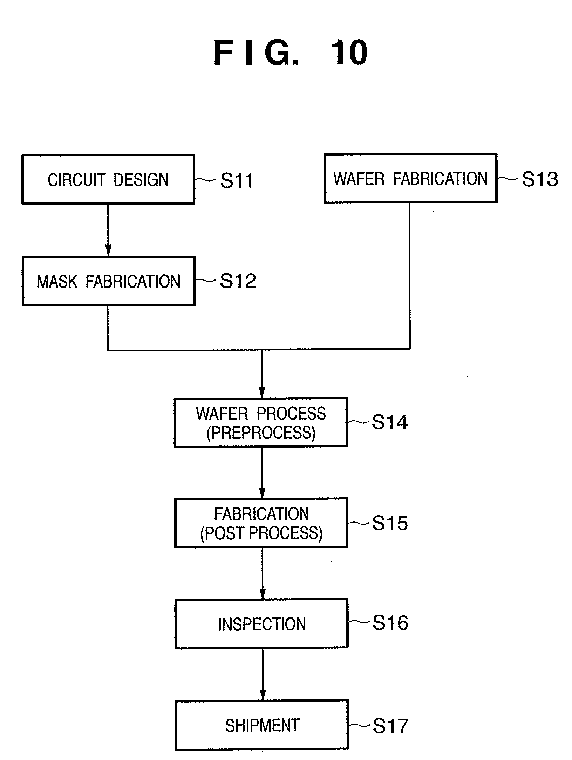

Next, a semiconductor device fabrication process utilizing the above-described exposure apparatus will be described. Fig. 10 shows the flow of entire semiconductor device fabrication process. At step S11 (circuit designing), a semiconductor device circuit designing is made. At step S12 (mask fabrication), a mask where the designed circuit pattern is formed is fabricated. On the other hand, at step S13 (wafer fabrication), a wafer is fabricated by using material such as silicon. At step S14 (wafer process), called a preprocess, an actual circuit is formed on the wafer by a lithography technique using the above mask and wafer. At the next step S15 (assembly), called a postprocess, a semiconductor chip is fabricated by using the wafer carrying the circuit formed at step S14. Step S15 includes an assembly process (dicing and bonding), a packaging process (chip encapsulation) and the like. At step S16 (inspection), inspections such as an operation check, a durability test and the like are performed on the semiconductor device formed at step S15. The semiconductor device is completed through these processes, and is shipped (step S17). The preprocess and the postprocess are performed in respective specialized factories, and maintenance is performed by a remote maintenance system in each factory. Further, data communication is performed between the factory for the preprocess and the factory for the postprocess to transfer information for apparatus maintenance.

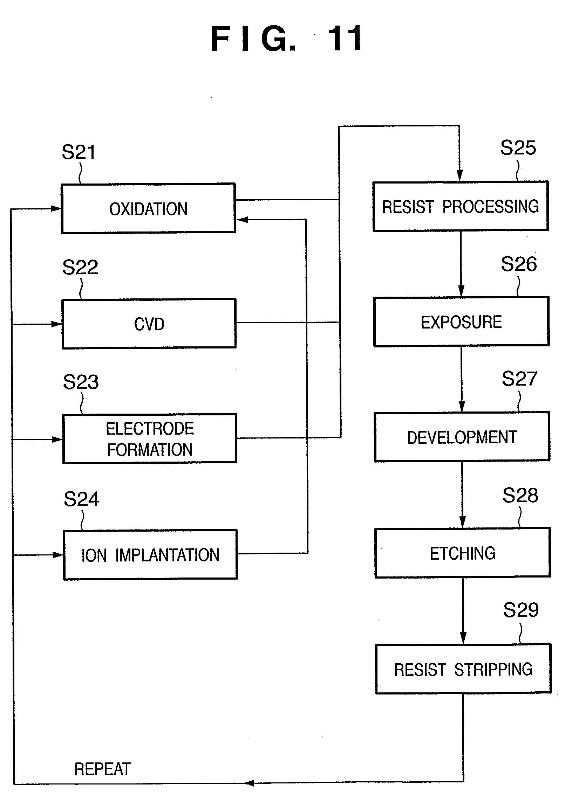

Fig. 11 shows the detailed flow of the wafer process. At step S21 (oxidation), the surface of the wafer is oxidized. At step S22 (CVD), an insulating film is formed on the surface of the wafer. At step S23 (electrode formation), electrodes are formed by vapor deposition on the wafer. At step S24 (ion implantation), ions are injected in the wafer. At step S25 (resist processing), the wafer is coated with photoresist. At step S26 (exposure), the mask circuit pattern is exposure-printed on the wafer by the above-described exposure apparatus. At step S27 (development), the exposed wafer is developed. At step S28 (etching), other portions than the developed resist are removed. At step S29 (resist stripping), the resist which is unnecessary after the completion of etching is removed. These steps are repeated, to form a multiple layers of circuit patterns on the wafer.

Note that the discharge plasma light source may be employed in the control procedure in the first embodiment, and further, the laser plasma light source may be employed in the control procedure in the second embodiment.

As described above, according to the present embodiments, practical plasma light source and exposure apparatus using the light source which prevent harmful effect on optical device can be realized. Especially, in an exposure apparatus using e.g. EUV light, the invention maintains a long life of multilayer film mirror, and prevents the fluctuations in the EUV light emission intensity due to the temperature change of the light source and accompanying change of the size of fine pattern and degradation of resolution and the like, thus enables stable transfer of fine pattern.

As many apparently widely different embodiments of the present invention can be made without departing from the spirit and scope thereof, it is to be understood that the invention is not limited to the specific embodiments thereof.

**Claims**

1. A plasma light source apparatus, **characterized by** comprising:

   a plasma light source that produces plasma light emission;
   an optical device to which a light emitted from said plasma light source is initially guided; and
   a shutter mechanism having a shutter capable of being inserted between said optical device and said plasma light source.

2. The plasma light source apparatus according to claim 1, **characterized in that** said shutter blocks radiated particles from said plasma light source arriving at said optical device.

3. The plasma light source apparatus according to claim 1, **characterized in that** said shutter is inserted in at least a predetermined period from start of light emission by said plasma light source.

4. The plasma light source apparatus according to claim 1, **characterized in that** said shutter is inserted in at least from start of light emission by said plasma light source until an intensity of the provided light becomes a predetermined range of intensity.

5. The plasma light source apparatus according to claim 1, **characterized in that** said plasma light source is a laser plasma light source.

6. The plasma light source apparatus according to claim 1, **characterized in that** said plasma light source is a discharge plasma light source.

7. The plasma light source apparatus according to claim 1, **characterized in that** said optical device is a mirror.

8. The plasma light source apparatus according to claim 7, **characterized in that** said mirror is coated with multilayer.

9. An exposure apparatus using a plasma light source apparatus according to claim 1.

10. The exposure apparatus according to claim 9, further **characterized by** comprising storage means for storing time indicative of a period from start of light emission by said plasma light source until an intensity of the provided light becomes a predetermined range of intensity, and
    wherein the emission of said plasma source is initiated with said shutter inserted and said shutter is removed after the time stored in said storage means passes.

11. The exposure apparatus according to claim 9, further **characterized by** comprising measurement means for measuring light emission intensity of said plasma light source, and
    wherein the emission of said plasma source is initiated with said shutter inserted and said shutter is removed after the light emission intensity measured by said measuring means becomes a predetermined range of intensity.

12. A device fabrication method utilizing the exposure apparatus according to claim 9.

13. A method of operating a plasma light source apparatus according to any one of claims 1 to 8, in which the plasma light source is operated to produce light, the shutter mechanism is repeatedly operated to remove and insert the shutter so as to define a plurality of exposure intervals, and the operation of the plasma light source is maintained to produce light throughout each of a plurality of non-exposure intervals, when the shutter is inserted, between respective ones of said exposure intervals.

# FIG. 1

EP 1 333 328 A2

# F I G. 2

# FIG. 3

301                                    302

# F I G.  4

EUV INTENSITY FLUCTUATIONS

EUV INTENSITY
( ARBITRARY UNIT )

TIME (SEC)

EP 1 333 328 A2

## F I G. 5A

PATTERN OF OPERATIONS OF LIGHT SOURCE AND SHUTTER

## F I G. 5B

PATTERN OF OPERATIONS OF LIGHT SOURCE AND SHUTTER

FIG. 6

# FIG. 7

RETICLE-STAGE
SCANNING
DIRECTION

RETICLE

RING EXPOSURE FIELD

PROJECTION
OPTICAL SYSTEM

RING EXPOSURE FIELD

WAFER

Z

X        Y

MASK-STAGE
SCANNING DIRECTION

# F I G. 8

```
                          ┌─────────┐
                          │  START  │
                          └─────────┘
                               │
                               ▼
              ┌───────────────────────────────┐
              │    START TRANSFER OF WAFER     │──── S801
              └───────────────────────────────┘
                               │
                               ▼ ◄──────────────────────┐
                          S802                           │
                         ╱        ╲                      │
                       ╱  2 SECONDS  ╲     NO            │
                      ◄  BEFORE EXPOSURE ───────────────┘
                       ╲      ?      ╱
                         ╲        ╱
                           │ YES
                           ▼
              ┌───────────────────────────────┐
              │      START LIGHT EMISSION      │──── S803
              │    BY PLASMA LIGHT SOURCE      │
              └───────────────────────────────┘
                               │
                               ▼ ◄──────────────────────┐
                          S804                           │
                         ╱        ╲     NO              │
                       ╱ EXPOSURE START ╲───────────────┘
                       ╲   TIMING ?    ╱
                         ╲        ╱
                           │ YES
                           ▼ ◄────────────────┐
              ┌───────────────────────────┐   │
              │    MOVE TO SHOT POSITION   │── S805
              └───────────────────────────┘   │
                           │                   │
                           ▼                   │
              ┌───────────────────────────┐   │
              │        OPEN SHUTTER        │── S806
              └───────────────────────────┘   │
                           │                   │
                           ▼                   │
              ┌───────────────────────────┐   │
              │          EXPOSURE          │── S807
              └───────────────────────────┘   │
                           │                   │
                           ▼                   │
              ┌───────────────────────────┐   │
              │        CLOSE SHUTTER       │── S808
              └───────────────────────────┘   │
                           │                   │
                           ▼      S809         │
                         ╱        ╲     NO     │
          ┌────────╲   ╱  EXPOSURE  ╲──────────┘
          │         ◄     END ?
 S811     │          ╲            ╱
          │            ╲        ╱
 ┌──────────────┐        │ YES
 │ PLASMA LIGHT │        ▼      S810
 │ SOURCE OFF   │      ╱        ╲
 └──────────────┘    ╱            ╲
          ▲  YES   ◄  NEXT WAFER ?
          └────────  ╲            ╱
                       ╲        ╱
                         │ NO
                         ▼
                    ┌─────────┐
                    │   END   │
                    └─────────┘
```

# F I G.  9

START

START TRANSFER OF WAFER — S901

S902
PREDETERMINED TIME BEFORE EXPOSURE ? — NO

YES

START LIGHT EMISSION BY PLASMA LIGHT SOURCE — S903

S904
START OF EXPOSURE POSSIBLE AND LIGHT-EMISSION INTENSITY STABLE ? — NO

YES

MOVE TO SHOT POSITION — S905

OPEN SHUTTER — S906

EXPOSURE — S907

CLOSE SHUTTER — S908

S911
PLASMA LIGHT SOURCE OFF

S909
NO — EXPOSURE END ?

YES

S910
YES — NEXT WAFER ?

NO

END

# F I G. 10

| | |
|---|---|
| CIRCUIT DESIGN ~S11 | WAFER FABRICATION ~S13 |

MASK FABRICATION ~S12

WAFER PROCESS
(PREPROCESS) ~S14

FABRICATION
(POST PROCESS) ~S15

INSPECTION ~S16

SHIPMENT ~S17

# F I G. 11

S21
OXIDATION

S22
CVD

S23
ELECTRODE FORMATION

S24
ION IMPLANTATION

S25
RESIST PROCESSING

S26
EXPOSURE

S27
DEVELOPMENT

S28
ETCHING

S29
RESIST STRIPPING

REPEAT